# FASCICULE DE BREVET EUROPEEN

(11) **EP 4 162 533 B1**
(45) Date de publication et mention de la délivrance du brevet: **03.09.2025**
(21) Numéro de dépôt: 21758402.8
(22) Date de dépôt: 26.07.2021
(51) Int. Cl.: H10F 19/90

(54) **PROCÉDÉ DE RÉALISATION D'UN ASSEMBLAGE DE CELLULES SOLAIRES SE CHEVAUCHANT PAR UNE STRUCTURE D'INTERCONNEXION**
VERFAHREN ZUR HERSTELLUNG EINER ANORDNUNG VON SOLARZELLEN, DIE ÜBER EINE VERBINDUNGSSTRUKTUR ÜBERLAPPEN
METHOD FOR PRODUCING AN ASSEMBLY OF SOLAR CELLS OVERLAPPING VIA AN INTERCONNECTION STRUCTURE

(30) Priorité: 29.07.2020 FR 2007989
(43) Date de publication de la demande: 12.04.2023
(73) Titulaire: Commissariat à l'Energie Atomique et aux Energies Alternatives, 75015 Paris (FR)
(72) Inventeur: CHAMBION, Bertrand, 38054 GRENOBLE CEDEX 09 (FR)
(74) Mandataire: Brevalex
(86) Numéro de dépôt international: PCT/FR2021/051393
(87) Numéro de publication internationale: WO 2022/023659

(56) Documents cités:
- EP-A1- 3 312 889
- WO-A1-2017/190398
- BEAUCARNE GUY: "MATERIALS CHALLENGE FOR SHINGLED CELLS INTERCONNECTION Introduction to Dow Corning", 3 May 2016 (2016-05-03), pages 1 - 17, XP055856118, Retrieved from the Internet <URL:http://www.metallizationworkshop.info/fileadmin/metallizationworkshop/favicon/8.3_Beaucarne_Metallization_Workshop_2016_presentation_v2.pdf> [retrieved on 20211028]

## Description

### DOMAINE TECHNIQUE

La présente demande concerne le domaine des cellules photovoltaïques (PV), également appelées cellules solaires et plus particulièrement celui de leur assemblage et de leur interconnexion.

Elle a trait à un assemblage de cellules solaires doté d'une structure d'interconnexion particulière, à la réalisation d'un tel assemblage ainsi qu'à un module photovoltaïque comportant un tel assemblage.

### ÉTAT DE LA TECHNIQUE ANTÉRIEURE

Une technique conventionnelle d'interconnexion de cellules solaires est basée sur l'utilisation d'un ruban métallique conducteur électrique qui assure la connexion électrique entre une cellule et la cellule suivante.

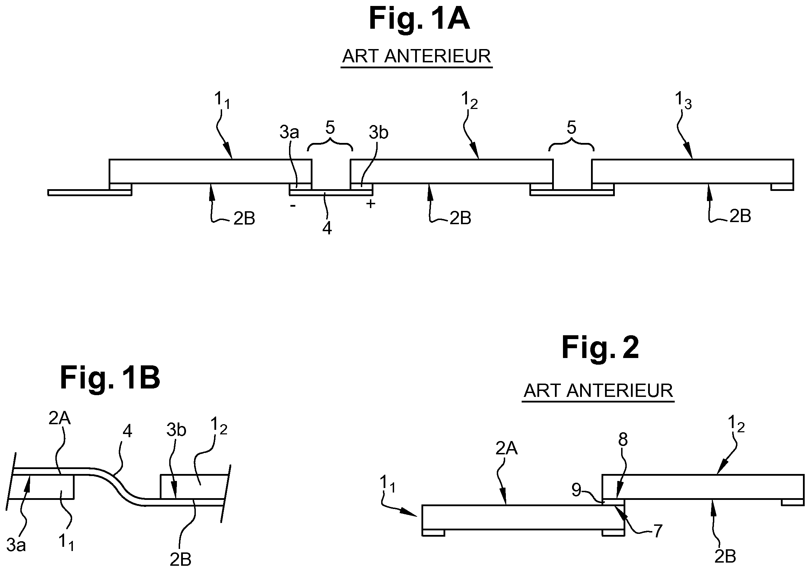

Un tel type d'interconnexion est illustré sur la figure 1A dans le cas particulier de cellules 1₁, 1₂, 1₃ à contact en face arrière (RCC), le ruban métallique 4 reliant ici une électrode 3a disposée en face arrière 2B d'une cellule 1₁, 1₂ et une électrode 3b disposée en face arrière d'une autre cellule 1₂, 1₃.

Selon une variante, illustrée sur la figure 1B, le ruban métallique 4 relie ici une électrode 3a disposée en face avant 2A d'une cellule 1₁, et une électrode 3b disposée en face arrière 2B d'une autre cellule 1₂.

Dans ce cas, les cellules sont généralement disposées les unes à côté des autres et il en résulte une surface 5 qui est perdue entre les cellules, qui augmente l'encombrement de l'assemblage et que l'on qualifie par conséquent de « zone morte ».

Une autre technique d'assemblage appelée « Shingle » (en français tuilage), permet de limiter l'encombrement et consiste à superposer les bords de cellules 1₁, 1₂, sur une faible surface. L'interconnexion entre une zone conductrice 7 en face avant 2A d'une cellule 1₁ et une zone conductrice 8 en face arrière 2B d'une autre cellule 1₂ est alors réalisée par le biais d'un matériau conducteur 9, de type matériau de brasure rapporté au niveau d'une zone de recouvrement entre les cellules ou colle conductrice de type ECA (pour Electro Conductive Adhésive) à base Acrylate ou Epoxy. Cette structure d'interconnexion présente pour avantage de ne pas réaliser de zone morte entre cellules 1₁, 1₂. Toutefois, elle aboutit à une structure mécanique rigide qui peut être fragile lorsqu'elle subit des sollicitations thermomécaniques importantes.

Le document « Materials Challenge for shingled cells interconnection » de Beaucarne et al., 6th workshop on metallization and interconnection for crystalline silicon solar cells, 2016, propose un assemblage de type Shingle en utilisant une colle de type ECA (ECA pour « Electrically Conductive Adhesive ») avec base silicone (plus souple mécaniquement que l'acrylate ou l'Epoxy) afin de rendre l'assemblage final plus souple. Une telle structure autorise toutefois peu de déformation dans le plan des cellules. Le document WO 2017/190398 A1 concerne une structure de connexion dans un assemblage de cellules solaires se chevauchant.

Il se pose le problème de trouver une nouvelle technique d'interconnexion améliorée vis-à-vis d'inconvénients énoncés ci-dessus.

### EXPOSÉ DE L'INVENTION

Selon l'invention, on prévoit un procédé de réalisation d'un assemblage de cellules solaires, selon la revendication 1. L'assemblage de cellules solaires décrit ci-dessous ne fait pas partie de l'invention mais représente un élément qui est utile à la compréhension de l'invention. On décrit la réalisation d'un assemblage de cellules solaires comprenant :
- une première cellule solaire connectée à une deuxième cellule solaire, la deuxième cellule solaire étant agencée de sorte qu'une zone périphérique d'une face arrière de la première cellule appelée « première zone périphérique » chevauche une zone périphérique de la face avant de la deuxième cellule appelée « deuxième zone périphérique », l'assemblage comprenant en outre :
   - une structure de connexion agencée en regard et entre ladite première zone périphérique et ladite deuxième zone périphérique,
   ladite structure de connexion étant formée :
   - d'au moins une portion conductrice oblongue,
   - d'une succession de blocs conducteurs agencés contre et en contact de ladite portion conductrice oblongue et dans une zone de chevauchement entre ladite première zone périphérique et ladite zone périphérique, lesdites blocs conducteurs étant alternativement répartis sur une première région (typiquement une première face) de portion conductrice oblongue et sur une deuxième région (typiquement une deuxième face opposée à la première face) de ladite portion conductrice oblongue opposée à ladite première région, un ou plusieurs premiers blocs parmi lesdits premiers blocs conducteurs étant en contact avec ladite première zone périphérique, un ou plusieurs deuxièmes blocs conducteurs étant en contact avec ladite deuxième zone périphérique.

Une telle structure permet de réaliser un découplage mécanique entre les cellules et de conférer à l'assemblage une souplesse accrue qui le rend davantage résistant à des sollicitions thermomécaniques.

De préférence l'ensemble desdits un ou plusieurs deuxièmes blocs conducteurs est décalé par rapport à l'ensemble desdits un ou plusieurs premiers blocs conducteurs, ce qui permet une meilleure déformation dans un plan parallèle aux cellules et contribue à rendre l'assemblage plus souple et donc résistant à certaines sollicitions thermomécaniques.

Avantageusement, un ou plusieurs ou chacun desdits un ou plusieurs premiers blocs conducteurs peut être en regard d'un espace vide et/ou d'une zone de matériau isolant disposé(e) entre ladite deuxième région de ladite portion conductrice oblongue et de ladite deuxième zone périphérique.

Avantageusement, un ou plusieurs deuxième(s) blocs conducteurs ou chacun des deuxièmes blocs conducteurs peut être agencé en regard d'un espace vide et/ou d'une zone de matériau isolant disposé(e) entre ladite première région de ladite portion conductrice oblongue et ladite première zone périphérique.

Selon une possibilité de mise en œuvre ce matériau isolant peut est un matériau polymère. Un tel type de matériau a pour avantage de présenter un faible module d'Young ce qui favorise la souplesse de l'assemblage.

Selon un mode de réalisation particulier, au moins un desdits un ou plusieurs premiers blocs conducteurs peut être entouré d'une zone isolante de passivation agencée entre ladite première région de portion conductrice oblongue et ladite première zone périphérique de la première cellule.

Selon un mode de réalisation particulier, au moins un desdits un ou plusieurs deuxièmes blocs conducteurs peut être entouré d'une zone isolante de passivation agencée entre ladite deuxième région de ladite portion conductrice oblongue et ladite première zone périphérique de la première cellule.

La portion conductrice oblongue peut être avantageusement sous forme d'au moins un fil conducteur, ou de plusieurs fils conducteurs distincts juxtaposés voire d'une bande conductrice, en particulier plane.

Un mode de réalisation particulier prévoit desdits blocs conducteurs sous forme de points de colle conductrice, en particulier une colle en matériau polymère chargé en particules conductrices, telle qu'une colle de type ECA. Dans ce cas, la souplesse de l'assemblage peut être favorisée.

Dans ce cas, on peut obtenir une structure de connexion ayant une résistance de contact électrique plus faible.

Selon un mode de réalisation particulier lesdits blocs conducteurs ont une forme sensiblement rectangulaire ou sensiblement parallélépipédique avec des coins arrondis. Une telle forme des blocs conducteurs peut permettre également d'obtenir une souplesse accrue de la structure.

L'invention concerne un procédé de réalisation d'un module solaire doté d'un assemblage tel que défini plus haut.

L'invention concerne plus spécifiquement un procédé de réalisation d'un assemblage de cellules solaires, ledit assemblage comprenant une première cellule connectée à une deuxième cellule, ladite deuxième cellule étant agencée de sorte qu'une zone périphérique d'une face arrière de la première cellule appelée « première zone périphérique », chevauche une zone périphérique de la face avant de la deuxième cellule appelée « deuxième zone périphérique »,
le procédé comprenant des étapes de :
- réalisation d'une structure de connexion formée : d'au moins une portion conductrice oblongue, et d'une succession de blocs conducteurs lesdits blocs conducteurs faisant saille sur la portion oblongue et étant des points de colle conductrice lesdits blocs conducteurs étant agencés alternativement sur une première région de portion conductrice oblongue et sur une deuxième région de ladite portion conductrice oblongue opposée à ladite première région, puis,
- assemblage de la structure de connexion avec la première cellule et la deuxième cellule, la structure de connexion étant agencée en regard et entre ladite première zone périphérique et ladite deuxième zone périphérique, dans une zone de chevauchement entre ladite première zone périphérique et ladite deuxième zone périphérique, un ou plusieurs premiers blocs parmi lesdits premiers blocs conducteurs étant en contact avec ladite première zone périphérique, un ou plusieurs deuxièmes blocs conducteurs étant en contact avec ladite deuxième zone périphérique, l'ensemble desdits un ou plusieurs deuxièmes blocs conducteurs étant décalé par rapport à l'ensemble desdits un ou plusieurs premiers blocs conducteurs.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
Les figures 1A, 1B servent à illustrer une technique conventionnelle d'assemblage et d'interconnexion de cellules solaires au moyen d'un ruban conducteur ;
La figure 2 sert à illustrer une autre technique d'assemblage et d'interconnexion de cellules solaires suivant l'art antérieur, dans laquelle les cellules solaires se chevauchent et sont connectées par le biais d'un matériau de brasure ou d'un matériau ECA ;
Les figures 3, 4, 5 et 6 servent à illustrer une structure d'interconnexion et d'assemblage de cellules solaires suivant un mode de réalisation, l'assemblage étant réalisé sans zone morte et ayant une souplesse accrue ;
La figure 7 sert à illustrer le comportement de la structure d'interconnexion lorsqu'elle subit une sollicitation thermique et/ou mécanique ;
La figure 8 servent à illustrer des différences de performances en termes de densité moyenne d'énergie accumulée dans une structure de connexion par rapport à une structure de connexion conventionnelle ;
Les figures 9A, 9B servent à illustrer différentes densités de blocs conducteurs de contact dans un structure d'interconnexion de cellule solaire telle que mis en œuvre suivant l'invention ;
La figure 10 sert à illustrer des différences de performances électrique entre une structure d'interconnexion et une structure d'interconnexion telle que mis en œuvre suivant la présente invention ;
Les figures 11, 12, 13 et 14 servent à illustrer une variante de structure d'interconnexion de cellules solaires doté de plusieurs fils conducteurs parallèles distincts ;
Les figures 15,16 servent à illustrer une autre une variante de structure d'interconnexion de cellules solaires ;
Les figures 17A, 17B, 17C et 17D servent à illustrer des étapes d'un exemple de procédé d'assemblage et d'interconnexion de cellules solaires tel que mis en œuvre suivant un mode de réalisation de la présente invention ;
Les figures 18A, 18B, 18C et 18D servent à illustrer un autre exemple de procédé d'assemblage et d'interconnexion de cellules solaires tel que mis en œuvre suivant un mode de réalisation de la présente invention ;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes qui dépendent de l'orientation de la structure tels que « avant », « supérieure », « arrière », « inférieure », « latérale », « centrale », « périphérique » s'appliquent en considérant que la structure est orientée de la façon illustrée sur les figures.

### EXPOSÉ DÉTAILLÉ DE MODES DE RÉALISATION PARTICULIERS

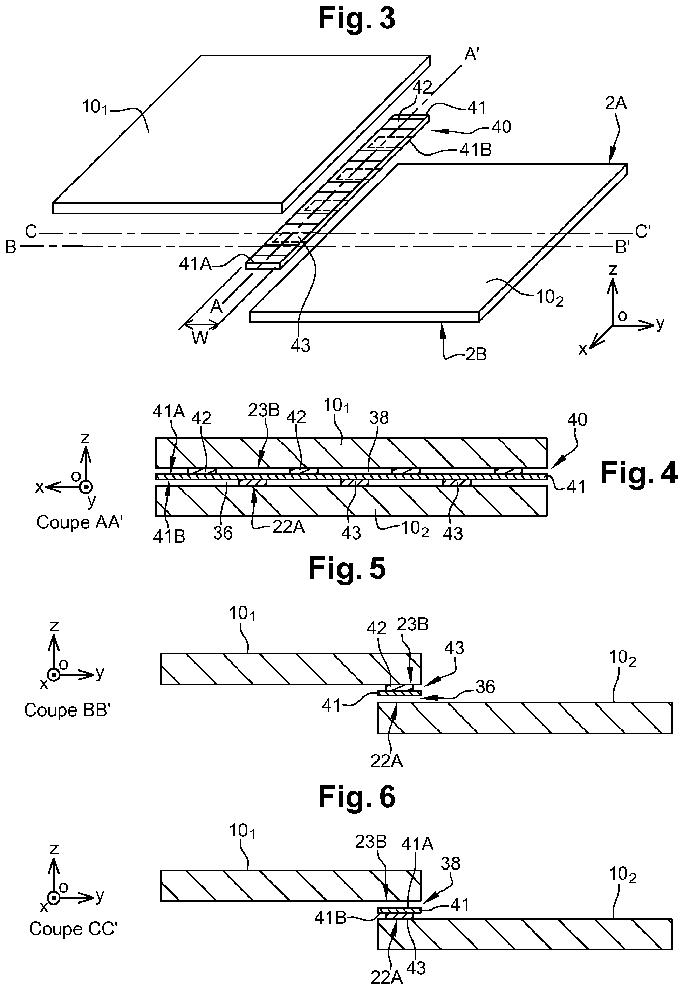

On se réfère à présent à la figure 3 donnant (par le biais d'une vue éclatée) un assemblage de cellules solaires 10₁, 10₂ tel que mis en œuvre suivant un mode de réalisation de la présente invention.

Les cellules solaires 10₁, 10₂, sont formées à partir d'un substrat semiconducteur, qui peut être poly ou mono-cristallin et en particulier à base de silicium polycristallin ou monocristallin. Chacune des cellules 10₁, 10₂ est dotée d'au moins une face 2A dite « face avant », réceptrice de lumière et qui est destinée à être exposée au rayonnement solaire, et d'une face 2B appelée « face arrière », opposée à la face avant 2A. La face arrière 2B peut être éventuellement également destinée à être exposée au rayonnement solaire. Dans ce cas particulier, la cellule est dite « bifaciale ».

Au moins une première cellule solaire 10₁, de cet assemblage est prévue avec des contacts répartis sur la face arrière 2B, dont un ou plusieurs contacts (non représentés) avec respectivement une ou plusieurs zones dopées de type N (autrement dit ayant un dopage produisant un excès d'électrons) et un ou plusieurs contacts (non représentés sur cette figure) avec respectivement une ou plusieurs zones dopées de type P (autrement dit selon un dopage consistant à produire un déficit d'électrons), la ou les zones de type N associé(es) à la ou les zones de type P formant au moins une jonction.

L'assemblage est tel qu'une zone périphérique 23B située sur la face arrière 2B de la première cellule 10₁ est disposée en regard d'une zone périphérique 22A de la face avant 2A d'une deuxième cellule 10₂.

Les cellules solaires 10₁, 10₂, sont ainsi ici assemblées selon un assemblage de type appelé « shingle », autrement dit de sorte à se chevaucher partiellement, ce qui permet notamment de réaliser un montage compact. Le chevauchement peut être prévu sur une distance typiquement d'au moins 0.2 mm et qui peut être comprise par exemple entre 0.5 mm et plusieurs millimètres.

Outre l'assemblage, la connexion des cellules 10₁, 10₂ entre elles est réalisée ici à l'aide d'une structure de connexion 40 particulière qui est agencée entre les cellules 10₁, 10₂, et est de préférence confinée au niveau d'une région où elles se chevauchent.

Cette structure de connexion 40 est formée d'une portion conductrice oblongue 41 qui, dans l'exemple de réalisation particulier illustré sur la figure 3, est sous forme d'une bande conductrice. Sur et en contact de la surface externe de cette portion conductrice oblongue 41, des blocs conducteurs 42, 43 faisant saillie sont prévus pour être mis en contact respectivement avec les cellules solaires 10₁, 10₂ et permettre d'assurer une connexion électrique d'une cellule à l'autre.

Les blocs conducteurs 42, 43 sont répartis alternativement sur une première région 41A de ladite portion conductrice 41 placée en regard de la zone périphérique 23B de la première cellule 10₁ et sur une deuxième région 41B, opposée à la première région, de ladite portion conductrice 41, la deuxième région étant disposée en regard de la zone périphérique 22A de la deuxième cellule 10₂. Dans le cas où la portion conductrice oblongue 41 est sous forme d'une bande conductrice de forme plane, la première région 41A et la deuxième région 41B sont respectivement une première face 41A et une deuxième face 41B opposée à la première face 41A.

La structure de connexion 40 comporte ainsi une ou plusieurs premiers blocs conducteurs 42 sur la première face 41A et un ou plusieurs deuxièmes blocs conducteurs 43 sur la face 41B opposée à la première face 41A.

Le fait de confiner la structure de connexion 40 et les blocs conducteurs 42, 43 au niveau de la région de chevauchement des cellules 10₁, 10₂ permet ne pas obstruer des parties, y compris de la face arrière 2B, que l'on pourrait vouloir exposer au rayonnement solaire.

Afin de conférer de la souplesse à l'assemblage, les blocs 42, 43 sont ici répartis le long d'un axe AA', alternativement sur la première face 41A et sur la deuxième face 41B, avec, de préférence, un décalage prévu d'un bloc conducteur 42 à l'autre 43 le long de cet axe AA'. L'ensemble du ou des blocs 42 formé sur la première face 41A est ainsi décalé de l'ensemble du ou des blocs 43 situé sur la deuxième face 41B.

Ainsi, dans la succession de blocs conducteurs 42, 43, le long de l'axe AA' chaque bloc conducteur 43 est décalé du bloc 42 suivant.

Ainsi, comme le montrent les figures 4, 5, 6 (donnant des vue en coupe de l'assemblage respectivement selon un axe AA', un axe BB', un axe CC' donnés sur la figure 1), les blocs conducteurs 42 et les blocs conducteurs 43 sont désalignés de sorte qu'un bloc conducteur 42 situé sur la première face 41A de la bande conductrice 41 et en contact avec la première cellule 10₁ n'est pas disposé en regard ou entièrement en regard d'un deuxième bloc conducteur 43 de la deuxième face 41B mais plutôt d'au moins un espace 36 prévu entre la deuxième face 41B et la deuxième cellule 10₂. De même, un bloc conducteur 43 situé sur la deuxième face 41B de la bande conductrice 41 et en contact avec la deuxième cellule 10₂ n'est pas disposé en regard ou entièrement en regard d'un premier bloc conducteur 42 situé sur la première face 41A mais d'au moins un espace 38 prévu entre la deuxième face 41B et la première cellule 10₁.

Cet agencement implique que la connexion électrique entre les deux cellules 10₁ et 10₂ n'est pas établie selon un chemin de conduction vertical (axe parallèle au vecteur z du repère orthogonal [O ;x ;y ;z]), mais selon un chemin en 'S'. Un tel agencement permet de favoriser un découplage mécanique entre les cellules 10₁, 10₂ et autorise une déformation des cellules 10₁, 10₂ suite à une sollicitation thermomécanique ou bien suite à une manipulation de l'assemblage de cellules 10₁, 10₂.

La portion conductrice 41 oblongue, lorsqu'elle est sous forme de bande, peut être prévue avec une largeur W (plus petite dimension mesurée dans un plan parallèle aux cellules et au plan [O ; x ; y ]) comprise par exemple entre 0,1 et plusieurs millimètres, et avantageusement entre 0,2 mm et 1 mm. Typiquement, la largeur W de la bande correspond à la largeur de recouvrement entre les cellules 10₁, 10₂, par exemple de l'ordre de 1 mm. La bande peut être également prévue avec une épaisseur e (dimension mesurée parallèlement à l'axe z) comprise par exemple entre 10 µm et 500 µm, par exemple de l'ordre de 50 µm. La bande peut éventuellement s'étendre sur toute la longueur d'une cellule.

Les blocs conducteurs 42, 43 peuvent être quant à eux prévus avec une épaisseur comprise par exemple entre 5 µm et 200 µm, par exemple de l'ordre de 50 µm. Cette épaisseur est adaptée notamment en fonction du nombre de blocs, de leur surface et de leur pas de répartition sur la portion conductrice 41 oblongue.

En ce qui concerne la composition de la structure, la portion 41 conductrice oblongue peut être formée d'un ou plusieurs matériau(x) métallique(s) tels que par exemple du cuivre ou de l'argent ou du cuivre étamé. Un mode de réalisation particulier prévoit une portion conductrice 41 formée d'un cœur en matériau conducteur, en particulier un matériau métallique tel que du cuivre ou de l'argent, revêtu de zones de matériau isolant formant une gaine isolante discontinue autour des blocs conducteurs. Le matériau isolant peut être un polymère, par exemple un polyimide tel que le Kapton^{™}.

Les blocs conducteurs 42, 43 sont typiquement en un matériau différent de celui de la portion conductrice oblongue 41 et peuvent être en particulier rapportés sur cette portion conductrice oblongue 41 typiquement sous forme de points de colle conductrice ou des zones de matériau de brasure.

Par exemple, lorsque les blocs conducteurs 42, 43 sont des zones de brasure, ils peuvent être formés en un alliage métallique de type étain-argent-cuivre (SnAgCu, également connu sous le nom de SAC) qui est un alliage sans plomb. Un alliage de type "SAC305" composé de plus de 95% d'étain, de l'ordre de 3,0% d'argent et de l'ordre de 0,5% de cuivre peut être en particulier utilisé.

Lorsque les blocs conducteurs 42, 43 sont des points de colle conductrice, une colle ECA (pour « Electrically Conductive Adhesive ») peut être utilisée. Une telle colle est formée d'une matrice polymère, typiquement de type époxyde, Acrylate ou silicone, chargée en particules conductrices. Par exemple une colle époxy argent de type EPO-TEK^{®} H20E, Loctite^{®} 8282 ou Loctite^{®} 8311 peuvent être en particulier utilisées.

Ainsi, avec une telle structure de connexion 40, les blocs conducteurs 42, 43 assurent à la fois le contact mécanique et électrique sur les cellules 10₁, 10₂, tandis que la portion oblongue 41 permet d'assurer le découplage mécanique entre les cellules et à l'assemblage de résister à des sollicitations thermique et/ou mécaniques.

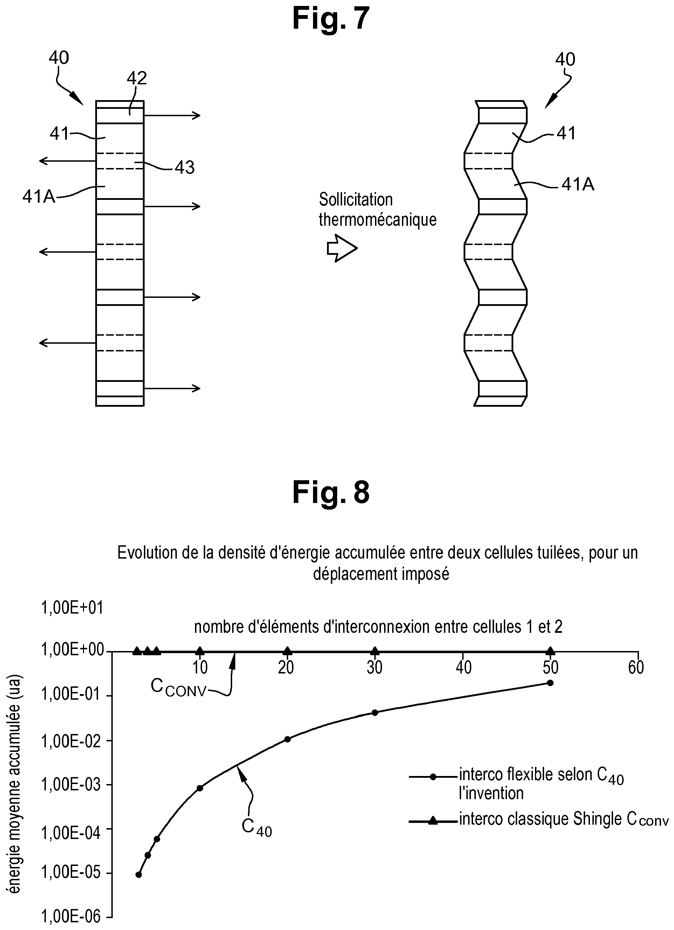

Comme cela est montré sur la figure 7, un tel découplage peut permettre à la structure de connexion 40 (représentée en vue de dessus) de se déformer lorsqu'elle subit une sollicitation thermique et/ou mécanique, sans pour autant venir dégrader les cellules, ces dernières étant typiquement réalisées en un matériau présentant une rigidité importante tel que le silicium.

Dans l'exemple de réalisation illustré sur les figures 3, 4, 5, 6 des espaces 38, 36 vides sont prévus entre la structure de connexion et les cellules 10₁, 10₂. En variante et comme suggéré précédemment, ces espaces peuvent être au moins partiellement comblés par au moins un matériau de passivation isolant, par exemple un matériau avec un faible module d'Young, en particulier un polymère tel que par exemple du Kapton^{™}.

Des simulations numériques de mise en contrainte au moyen de l'outil Ansys^{®} ont effectuées pour permettre de comparer une structure de connexion telle que décrite précédemment par rapport à une structure de connexion conventionnelle mettant en œuvre un simple ruban conducteur entre deux cellules se chevauchant. Des résultats d'une telle simulation sont donnés par le graphique de la figure 8.

Pour la structure conventionnelle, l'interconnexion est constituée d'un cordon continu de colle de type ECA de 50 µm d'épaisseur et de longueur de 156 mm, correspondant à un format M2 de cellules solaires. Le matériau de la colle est considéré comme ayant un module de Young à 1GPa.

On considère dans le même temps une structure de connexion telle que mise en œuvre suivant l'invention, avec au moins trois blocs conducteurs (deux sur une face, une sur une autre face) sur une bande conductrice en cuivre de longueur de 156 mm avec un module de Young pour le Cuivre de 124GPa.

On fait varier le nombre de blocs conducteurs de 3 à 50 pour apprécier l'évolution des capacités de déformation de la structure selon l'invention.

Pour chacun des modèles de simulations établis, une déformation arbitraire de 1 µm est appliquée.

Comme les géométries et les matériaux simulés ne sont pas identiques entre les deux structures, on ne compare pas des niveaux de contrainte mécanique. La donnée de sortie choisie pour établir la comparaison est ici une densité moyenne d'énergie élastique accumulée dans l'interconnexion complète suite à une déformation de 1 µm. Cette donnée peut être assimilée à l'inverse de la souplesse mécanique. Les résultats sont représentés par la courbe C₄₀ normalisée par rapport à l'interconnexion conventionnelle (C_{conv}).

On observe d'une part que la densité moyenne d'énergie élastique accumulée dans la structure de connexion suivant l'invention présente toujours une valeur inférieure à la structure de référence. En ce qui concerne l'influence du nombre de protubérances conductrices, même en considérant 50 protubérances (ce qui, dans le cas présent équivaut à un point de connexion électrique tous les 1,5 mm) le niveau d'énergie accumulé est 5 fois inférieur à celui présent dans le cas d'une structure de connexion conventionnelle.

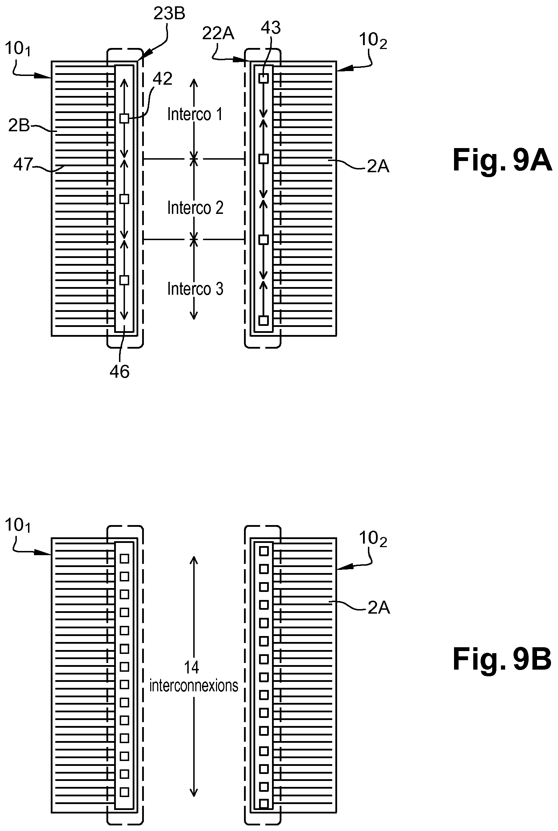

Les figures 9A et 9B montrent les cellules 10₁, 10₂ avant assemblage, avec différentes densités de blocs conducteurs 42, 43 au niveau des zones 23B, 22A

La figure 9A permet d'illustrer un premier cas d'un nombre n faible de blocs conducteurs, par exemple égale à 3, le long de chaque cellule. Dans ce cas, afin de distribuer le courant dans tous les doigts conducteurs 47 en surface de cellule, on peut prévoir une épaisseur plus importante des zones conductrices 46 sur lesquelles elles sont en contact et que l'on réalise par exemple par sérigraphie à la pâte d'Argent.

Dans un deuxième cas (figure 9B) d'un nombre important de blocs conducteurs le long des cellules à connecter (n=50), la zone conductrice 46 peut être prévue avec une épaisseur d'un assemblage Shingle conventionnel.

L'optimum géométrique de la structure de connexion et en particulier le nombre, la taille et la densité des blocs conducteurs 42, 43 dépend d'un compromis entre une souplesse mécanique nécessaire tout en garantissant une performance électrique suffisante de l'interconnexion.

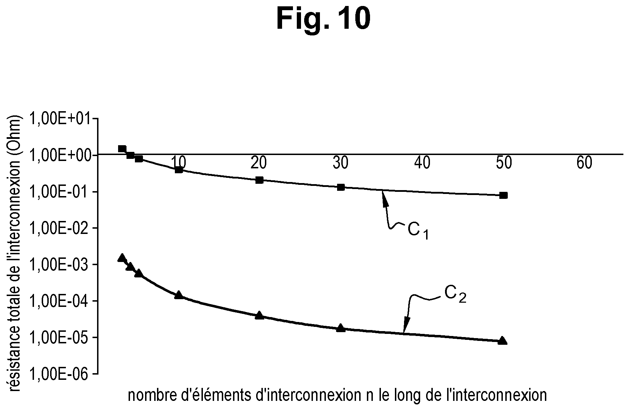

La figure 10 illustre le résultat d'une comparaison entre la résistance série d'une première structure de connexion suivant l'invention (courbe C₁) et celle d'une deuxième structure de connexion suivant l'invention (courbe C₂).

La première structure de connexion suivant l'invention (courbe C₁) est ici formée d'un ruban de Cuivre de dimensions épaisseur*longueur*largueur de 0,05*156*1mm et de blocs conducteurs faisant saillie sur le ruban et formés d'un matériau de brasure de type SAC305. Les zones de brasure ont des dimensions de 0,05*1*1mm (épaisseur*longueur*largueur).

La résistance série d'une deuxième interconnexion telle que mise en œuvre suivant l'invention avec des points de colle de type ECA est également illustrée (courbe C₂).

La comparaison est menée à l'aide d'un calcul analytique (R=(Rho*L)/S), avec R la résistance électrique du matériau, Rho la résistivité du matériau, L la longueur et S sa section, en considérant des résistivités pour le Cuivre de 17e-9 ohm.m, pour la brasure SAC305 : 1,3e-6 ohm.m, pour la colle ECA de 4^{e}-2 ohm.m.

Les résultats présentés sous forme de courbes C₁, C₂ en fonction du nombre n de points de colle ou de zones de brasure le long de la zone de recouvrement entre cellules.

La structure suivant l'invention permet d'utiliser un matériau de type brasure pour les connexions sur les cellules. On observe en effet que l'interconnexion proposée dans cette invention présente toujours une résistance électrique théorique inférieure à celle d'une structure conventionnelle.

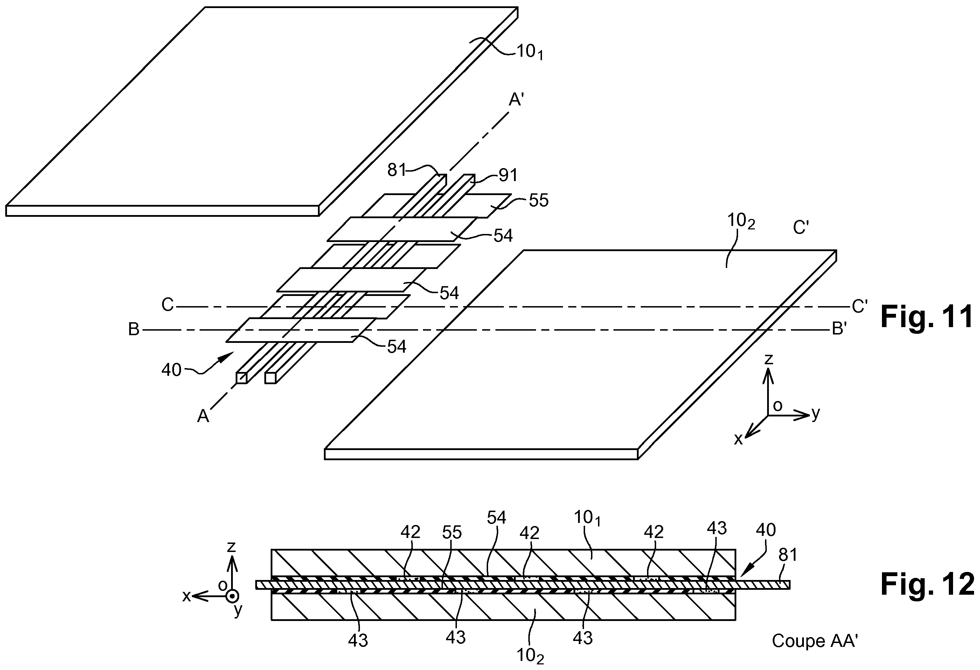

Un autre exemple de structure d'interconnexion entre cellules 10₁, 10₂ est donnée sur les figures 11 à 14 donnant respectivement une vue éclatée, une vue en coupe AA', une vue en coupe transversale BB', et une autre vue en coupe CC' selon un autre plan de coupe transversal). La portion oblongue de la structure de connexion prend cette fois la forme de fils conducteurs 81, 91 juxtaposés et de préférence disposés l'un parallèlement à l'autre.

Les blocs conducteurs 42, 43 (non représentés sur la figure 11 par souci de simplification) répartis respectivement sur les fils conducteurs 81, 91 et sous les fils conducteurs 81, 91 peuvent avoir un agencement semblable à celui décrit précédemment. La structure comporte ici des zones de passivation 54, 55 réparties respectivement sur les fils conducteurs 81, 91, et sous les fils conducteurs 81, 91. Ainsi, une ou plusieurs zones de passivation 54 sont agencées entre la première cellule 10₁ et une face supérieure des fils conducteurs 81, 91, tandis qu'une ou plusieurs autres zones de passivation 55 sont agencées entre la deuxième cellule 10₂ et une face inférieure des fils conducteurs 81, 91 opposée à a face supérieure. Chaque zone de passivation 54 (resp. 55) peut être prévue entre deux blocs conducteurs 42 (resp. 43).

Les zones de passivation 54, 55 peuvent être sous forme d'un film ou d'une couche en matériau isolant par exemple un matériau polymère tel que du Kapton^{™}, et transparent dans le cas où le film est plus large que la zone de recouvrement des cellules et que l'on rapporte sur les fils conducteurs 81, 91.

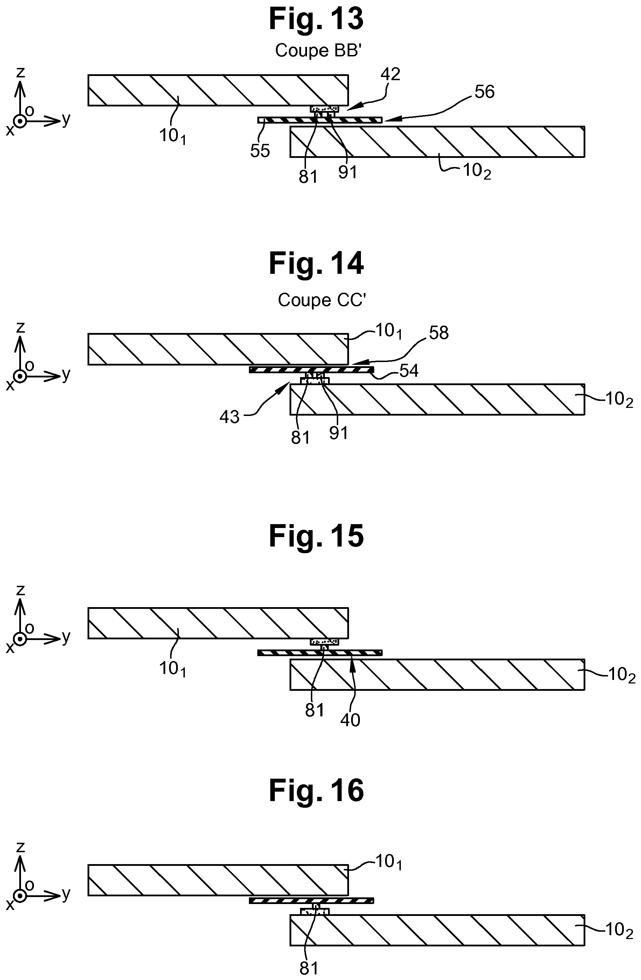

Comme on peut le voir sur les figures 13 et 14, l'épaisseur des zones de passivation peut être inférieure à celle des blocs conducteurs 42, 43 Un espace 56 vide (resp. 58) peut être ainsi ménagé entre une zone de passivation 55 (resp. 54) et la cellule 10₂ (resp. 10₂) en regard de laquelle cette zone de passivation est située.

Une variante de réalisation avec cette fois un seul fil conducteur 81 pour réaliser la connexion entre blocs conducteurs 42 connectés à la cellule 101 et blocs conducteurs 42 connectés à la cellule 101 est donnée sur les vues en coupe transversale des figures 15 et 16.

Le fil conducteur 81 a dans l'exemple illustré une forme parallélépipédique. Un fil de forme cylindrique peut également être utilisé.

En ce qui concerne sa fabrication, une structure de connexion 40 telle que décrite précédemment peut être réalisée de plusieurs manières.

Une première possibilité consiste à fonctionnaliser la portion oblongue 41 puis à réaliser l'assemblage avec les cellules. Ainsi, on forme les blocs conducteurs 42, 43 sur la portion oblongue 41, par exemple sur une face supérieure et sur une face inférieure d'une bande conductrice, puis on dispose la structure d'interconnexion de sorte qu'elle soit intercalée dans la zone de chevauchement entre les cellules 10₁, 10₂. On effectue ensuite l'assemblage.

On peut partir par exemple d'une bande conductrice sur laquelle on réalise un ou plusieurs blocs conducteurs, par exemple sous forme de points de colle conductrice sur une première face. Les blocs conducteurs peuvent être réalisées par exemple par sérigraphie en se servant d'un masquage, éventuellement temporaire, agencé sur la première face et comportant une ou plusieurs ouvertures dévoilant la première face de la bande conductrice.

Puis, on forme un ou plusieurs blocs conducteurs sur une deuxième face par exemple des points de colle conductrice sur une deuxième face opposée à la première face. De même, des blocs conducteurs peuvent être réalisées sur la deuxième face, par exemple par sérigraphie, en se servant par exemple du même masquage ou d'un autre masquage, éventuellement temporaire, agencé sur la deuxième face et comportant une ou plusieurs ouvertures dévoilant la deuxième face de la bande conductrice.

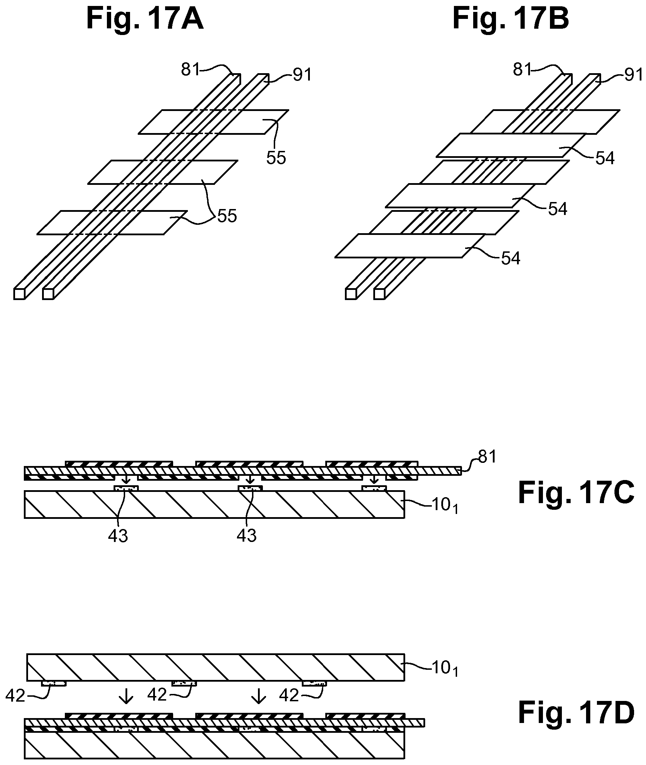

Une variante illustrée sur les figures 17A-17D, prévoit de réaliser des zones de passivation 55, par exemple en polymère sur une face ou d'un côté de la portion oblongue (figure 17A), ici formée de fils conducteurs 81, 91 juxtaposés, et d'autres zones de passivation 54 sur la face opposée ou du côté opposé. Puis, on assemble la structure ainsi obtenue avec une cellule 10₂ sur laquelle des blocs conducteurs 43 sous forme points de colle ou des zones de brasure sont disposé(e)s (figure 17C). Ensuite, on peut rapporter d'autres blocs conducteurs 42 sous forme de points de colle ou de zones de brasure sur l'autre cellule 10₁ que l'on assemble ensuite avec la structure précédemment obtenue (figure 17D).

En variante de cette étape, on peut rapporter les autres blocs conducteurs sous forme de points de colle ou de zones de brasure sur les fils conducteurs 81, 91 et on réalise ensuite l'assemblage avec l'autre cellule.

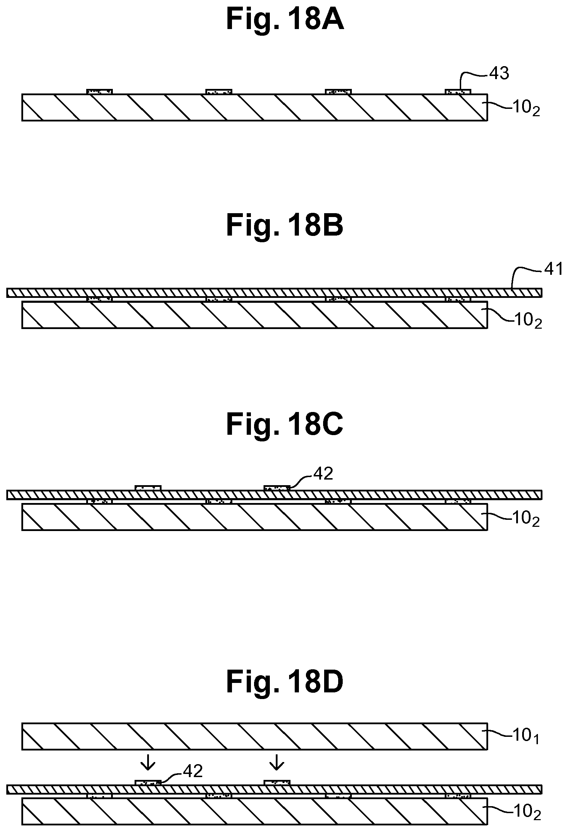

Selon une autre variante illustrée sur les figures 18A-18D, on peut prévoir tout d'abord de réaliser un ou plusieurs blocs conducteurs 43, par exemple des points de colle ou de brasure sur une zone périphérique d'une cellule solaire 10₂ (figure 18A). Puis, on dispose la portion conductrice oblongue 41 sur ces blocs conducteurs 43 (figure 18B).

Ensuite (figure 18C), on forme dans un autre ensemble de blocs conducteurs 42 sur la portion conductrice oblongue par exemple des points de colle ou de brasure. Puis (figure 18D) on dispose l'autre cellule 10₁ sur cet autre ensemble de blocs 42.

Une telle variante est adaptée en particulier lorsque les blocs sont sous forme de gouttes de brasure (pâte à braser).

Selon une autre variante, on peut également réaliser un ou plusieurs blocs conducteurs sur chaque cellule puis rapporter chaque cellule munie des blocs conducteurs sur une des faces de la bande conductrice.

Un mode de réalisation particulier prévoit de réaliser une distribution du matériau des blocs conducteurs simultanément en plusieurs points de la bande conductrice, par exemple au moyen d'une pluralité d'aiguilles de distribution délivrant des gouttes de colle, en particulier une colle ECA.

## Revendications

1. Procédé de réalisation d'un assemblage de cellules solaires, ledit assemblage comprenant une première cellule (10₁) connectée à une deuxième cellule (10₂), ladite deuxième cellule étant agencée de sorte qu'une zone périphérique (23B) d'une face arrière (2B) de la première cellule appelée « première zone périphérique », chevauche une zone périphérique (22A) de la face avant (2A) de la deuxième cellule appelée « deuxième zone périphérique »,
le procédé comprenant des étapes de :
- réalisation d'une structure de connexion (40) formée : d'au moins une portion conductrice (41) oblongue, et d'une succession de blocs conducteurs (42, 43) lesdits blocs conducteurs (42, 43) faisant saille sur la portion oblongue et étant des points de colle conductrice lesdits blocs conducteurs étant agencés alternativement sur une première région (41A) de portion conductrice oblongue (41, 81, 91) et sur une deuxième région (41B) de ladite portion conductrice oblongue (41) opposée à ladite première région (41A), puis,
- assemblage de la structure de connexion avec la première cellule et la deuxième cellule, la structure de connexion étant agencée en regard et entre ladite première zone (23B) périphérique et ladite deuxième zone périphérique (22A), dans une zone de chevauchement entre ladite première zone périphérique et ladite deuxième zone périphérique, un ou plusieurs premiers blocs (42) parmi lesdits premiers blocs conducteurs étant en contact avec ladite première zone périphérique (23B), un ou plusieurs deuxièmes blocs conducteurs (43) étant en contact avec ladite deuxième zone périphérique (22A), l'ensemble desdits un ou plusieurs deuxièmes blocs conducteurs (43) étant décalé par rapport à l'ensemble desdits un ou plusieurs premiers blocs conducteurs (42).

2. Procédé selon la revendication 1, dans lequel chacun desdits un ou plusieurs premiers blocs conducteurs (42) est agencé en regard d'un espace vide (36) et/ou d'une zone de matériau isolant disposé(e) entre ladite deuxième région (41B) de ladite portion conductrice oblongue (41) et ladite deuxième zone périphérique (22A) et/ou,
dans lequel chacun desdits un ou plusieurs deuxièmes blocs conducteurs (43) est agencé en regard d'un espace vide (38) et/ou d'une zone de matériau isolant (54) disposé(e) entre ladite première région (41A) de ladite portion conductrice oblongue (41) et ladite première zone périphérique (23B) de la première cellule (10₁).

3. Procédé selon la revendication 2, dans lequel ledit matériau isolant est un matériau polymère.

4. Procédé selon l'un des revendications 1 à 3, au moins un desdits un ou plusieurs premiers blocs conducteurs (42) étant entouré d'une zone isolante (55) de passivation agencée entre ladite première région (41A) de portion conductrice oblongue (41) et ladite première zone périphérique (23B).

5. Procédé selon l'un des revendications 1 à 4, au moins un desdits un ou plusieurs deuxièmes blocs conducteurs (43) étant entouré d'une zone isolante (54) de passivation agencée entre ladite deuxième région (41B) de ladite portion conductrice oblongue (41) et ladite deuxième zone périphérique (22A).

6. Procédé selon l'une des revendications 1 à 5, dans lequel ladite portion conductrice oblongue (41, 81, 91) est formée d'au moins un fil conducteur (81), ou de plusieurs fils conducteurs distincts juxtaposés (81, 91) ou d'une bande conductrice (41).

7. Procédé selon l'une des revendications 1 à 6, dans lequel lesdits blocs conducteurs (42, 43) sont dotés de coins arrondis.

## Patentansprüche

1. Verfahren zur Herstellung einer Solarzellenanordnung, wobei die Anordnung eine erste Zelle (10₁) umfasst, die mit einer zweiten Zelle (10₂) verbunden ist, wobei die zweite Zelle so angeordnet ist, dass ein Umfangsbereich (23B) einer Rückseite (2B) der ersten Zelle, der als "erster Umfangsbereich" bezeichnet wird, einen Umfangsbereich (22A) der Vorderseite (2A) der zweiten Zelle, der als "zweiter Umfangsbereich" bezeichnet wird, überlappt,
das Verfahren umfassend folgende Schritte:
- Herstellung einer Verbindungsstruktur (40), die gebildet wird aus : mindestens einem länglichen leitenden Abschnitt (41) und einer Folge von leitenden Blöcken (42, 43), wobei die leitenden Blöcke (42, 43) über den länglichen Abschnitt hinausragen und leitende Klebepunkte sind, wobei die leitenden Blöcke abwechselnd auf einem ersten Bereich (41A) des länglichen leitenden Abschnitts (41, 81, 91) und auf einem zweiten Bereich (41B) des länglichen leitenden Abschnitts (41), der dem ersten Bereich (41A) gegenüberliegt, angeordnet sind, und anschließend,
- Anordnung der Verbindungsstruktur mit der ersten Zelle und der zweiten Zelle, wobei die Verbindungsstruktur gegenüber und zwischen dem ersten Umfangsbereich (23B) und dem zweiten Umfangsbereich (22A) in einem Überlappungsbereich zwischen dem ersten Umfangsbereich und dem zweiten Umfangsbereich angeordnet ist, wobei ein oder mehrere erste Blöcke (42) unter den ersten leitenden Blöcken in Kontakt mit dem ersten Umfangsbereich (23B) stehen, ein oder mehrere zweite leitende Blöcke (43) in Kontakt mit dem zweiten Umfangsbereich (22A) stehen, wobei die Gruppe des einen oder der mehreren zweiten leitenden Blöcke (43) in Bezug auf die Gruppe des einen oder der mehreren ersten leitenden Blöcke (42) versetzt ist.

2. Verfahren nach Anspruch 1, wobei jeder des einen oder der mehreren ersten leitenden Blöcke (42) gegenüber einem Leerraum (36) und/oder einem Bereich aus Isoliermaterial angeordnet ist, der zwischen dem zweiten Bereich (41B) des länglichen leitenden Abschnitts (41) und dem zweiten Umfangsbereich (22A) angeordnet ist, und/oder
wobei jeder des einen oder der mehreren zweiten leitenden Blöcke (43) gegenüber einem Leerraum (38) und/oder einem Bereich aus Isoliermaterial (54) angeordnet ist, der zwischen dem ersten Bereich (41A) des länglichen leitenden Abschnitts (41) und dem ersten Umfangsbereich (23B) der ersten Zelle (10₁) angeordnet ist.

3. Verfahren nach Anspruch 2, wobei das Isoliermaterial ein Polymermaterial ist.

4. Verfahren nach einem der Ansprüche 1 bis 3, wobei mindestens einer des einen oder der mehreren ersten leitenden Blöcke (42) von einem isolierenden Passivierungsbereich (55) umgeben ist, der zwischen dem ersten Bereich (41A) des länglichen leitenden Abschnitts (41) und dem ersten Umfangsbereich (23B) angeordnet ist.

5. Verfahren nach einem der Ansprüche 1 bis 4, wobei mindestens einer der einen oder mehrere zweite leitende Blöcke (43) von einem isolierenden Passivierungsbereich (54) umgeben ist, der zwischen dem zweiten Bereich (41B) des länglichen leitenden Abschnitts (41) und dem zweiten peripheren Bereich (22A) angeordnet ist.

6. Verfahren nach einem der Ansprüche 1 bis 5, wobei der längliche leitende Abschnitt (41, 81, 91) aus mindestens einem leitenden Draht (81) oder aus mehreren nebeneinander angeordneten separaten leitenden Drähten (81, 91) oder aus einem leitenden Streifen (41) gebildet wird.

7. Verfahren nach einem der Ansprüche 1 bis 6, wobei die Leiterblöcke (42, 43) abgerundete Ecken aufweisen.

## Claims

1. A method for carrying out an assembly of solar cells, said assembly comprising a first cell (10₁) connected to a second cell (10₂), said second cell being arranged so that a peripheral zone (23B) of a rear face (2B) of the first cell called "first peripheral zone" overlaps with a peripheral zone (22A) of the front face (2A) of the second cell called "second peripheral zone",
the method comprising steps of:
- creating a connection structure (40) formed: by at least one oblong conductive portion (41), and by a succession of conductive blocks (42, 43), said conductive blocks (42, 43) protruding on the oblong portion and being spots of conductive glue, said conductive blocks being arranged alternatingly on a first region (41A) of an oblong conductive portion (41, 81, 91) and on a second region (41B) of said oblong conductive portion (41) opposite to said first region (41A), then
- assembling the connection structure with the first cell and the second cell, the connection structure being arranged facing and between said first peripheral zone (23B) and said second peripheral zone (22A), in a zone of overlap between said first peripheral zone and said peripheral zone, one or more first blocks (42) out of said first conductive blocks being in contact with said first peripheral zone (23B), one or more second conductive blocks (43) being in contact with said second peripheral zone (22A), the assembly of said one or more second conductive blocks (43) being offset with respect to the assembly of said one or more first conductive blocks (42).

2. The method according to claim 1, wherein each of said one or more first conductive blocks (42) is arranged facing an empty space (36) and/or a zone of insulating material disposed between said second region (41B) of said oblong conductive portion (41) and said second peripheral zone (22A), and/or
wherein each of said one or more second conductive blocks (43) is arranged facing an empty space (38) and/or a zone of insulating material (54) disposed between said first region (41A) of said oblong conductive portion (41) and said first peripheral zone (23B) of the first cell (10₁).

3. The method according to claim 2, wherein said insulating material is a polymer material.

4. The method according to one of claims 1 to 3, at least one of said one or more first conductive blocks (42) being surrounded by a passivation insulating zone (55) arranged between said first region (41A) of an oblong conductive portion (41) and said first peripheral zone (23B).

5. The method according to one of claims 1 to 4, at least one of said one or more second conductive blocks (43) being surrounded by a passivation insulating zone (54) arranged between said second region (41B) of said oblong conductive portion (41) and said second peripheral zone (22A).

6. The method according to one of claims 1 to 5, wherein said oblong conductive portion (41, 81, 91) is formed by at least one conductive wire (81), or several distinct juxtaposed conductive wires (81, 91) or a conductive strip (41).

7. The method according to one of claims 1 to 6, wherein said conductive blocks (42, 43) are provided with rounded corners.
